(19) **Europäisches Patentamt**
**European Patent Office**
**Office européen des brevets**

(11) **EP 4 687 248 A1**

(12) **EUROPEAN PATENT APPLICATION**

(43) Date of publication:
**04.02.2026 Bulletin 2026/06**

(21) Application number: **24192171.7**

(22) Date of filing: **31.07.2024**

(51) International Patent Classification (IPC):
***H02J 3/00*** *(2026.01)*  ***G01R 31/08*** *(2020.01)*
***H02H 7/26*** *(2006.01)*  ***H02J 13/00*** *(2026.01)*

(52) Cooperative Patent Classification (CPC):
**H02J 3/0012; G01R 31/086; H02H 7/261;**
**H02H 7/263; H02J 13/00002;** H02J 2203/20

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Hitachi Energy Ltd**
**8050 Zürich (CH)**

(72) Inventors:
• **WANG, Zhenyuan**
  **Apex, 27502 (US)**
• **CHMIELOWIEC, Krzysztof**
  **32-089 Beblo (PL)**
• **KNEZOVIC, Katarina**
  **8006 Zürich (CH)**
• **SHCHETININ, Dmitry**
  **5600 Lenzburg (CH)**

(74) Representative: **Vossius & Partner**
**Patentanwälte Rechtsanwälte mbB**
**Siebertstraße 3**
**81675 München (DE)**

(54) **DETERMINATION OF FAULT LOCATION BASED ON AUTOMATED METERING INFRASTRUCTURE (AMI) DATA**

(57)    State-of-the-art methods for locating a fault within a power distribution network rely on complex methods, such as optimization, which fail to fully leverage the wealth of information contained in automated metering infrastructure (AMI) data. Disclosed embodiments utilize the AMI data to generate power flow profiles (e.g., using an aggregation process) for fuses within the power distribution network. These power flow profiles, which define expected power flow as a function of time, are used to determine expected power flow through each fuse at any given time. Whenever a fault is detected by a measurement device, the drop in power flow through the measurement device is matched to the expected power flows of the downstream fuses, to determine a set of potentially blown downstream fuses. This significantly narrows the search space from which a final blown downstream fuse may be determined, without the computational expense required by state-of-the-art methods.

**FIG. 1**

EP 4 687 248 A1

**Description**

**BACKGROUND**

Field of the Invention

The embodiments described herein are generally directed to locating faults, and, more particularly, to the determination of fault location based on automated metering infrastructure (AMI) data.

Description of the Related Art

To reduce the impact of individual faults on customers, utilities have deployed reclosers, sectionalizers, and a massive number of fuses in their power distribution networks. When a downstream fuses experiences a permanent fault, the fuse will blow open and switch to an outage status, irrespective of any upstream reclosers' operations. In this case, the upstream reclosers and other types of line sensors (e.g., fault indicators, sectionalizers, etc.) will experience a change in the measured power flow, as well as a peak fault current. Historically, the advanced distribution management system (ADMS) that is managing the power distribution network will use this peak fault current for fault location, isolation, and service restoration (FLISR) functions. Conventionally, steady-state power measurements are not used for outage detection of a fuse.

Utilities in many countries have deployed automated metering infrastructure (AMI) for the purposes of billing customers. The "last gasp" of these meters can be used to detect outages, in lieu of trouble calls. The term "last gasp" refers to the final communication between the meter and the meter data management system (MDMS) before the meter loses power.

Automated metering infrastructure provides a wealth of information that is beneficial to outage detection, beyond just the last gasp. In particular, energy consumption, measured at fixed time intervals by the meters, provides real-time loading information that can be used to determine fault location.

For example, Y. Jiang, et al., "Outage Management of Distribution Systems Incorporating Information From Smart Meters," in IEEE Transactions on Power Systems, vol. 31, no. 5, pp. 4144-4154, Sep. 2016, doi: 10.1109/TPWRS.2015.2503341, utilizes available data from smart meters and fault indicators and an optimization method, based on integer programming, to determine the most credible actuated protective devices and faulted line sections. Additional methods for fault location are described in D. Hai, et al., "Fault Location System for Distribution Network Based on Incomplete Information from Multiple Sources," 2021 6th International Conference on Smart Grid and Electrical Automation (ICSGEA), Kunming, China, 2021, pp. 378-382, doi: 10.1109/ICSGEA53208.2021.00092, and D. S. Pereira, et al., "An Experience of Locating High-impedance Faults through Smart Meters' Alarms in Power Distribution Networks," CIRED 2021 - The 26th International Conference and Exhibition on Electricity Distribution, Online Conference, 2021, pp. 1727-1731, doi: 10.1049/icp.2021.1853. The present disclosure addresses one or more problems, in these state-of-the-art methods, discovered by the inventors.

SUMMARY

Systems, methods, and non-transitory computer-readable media are disclosed for determining fault location based on automated metering infrastructure (AMI) data. A first objective achievable by disclosed embodiments is leveraging AMI data for fault location without the complexity of an optimization process. A second objective achievable by disclosed embodiments is faster fault location, relative to traditional report-based methods. A third objective achievable by disclosed embodiments is improved accuracy in fault location.

In an embodiment, a method comprises using at least one hardware processor to, in response to a detection of a fault on a downstream power distribution network by an upstream measurement device that is upstream from the downstream power distribution network, identify a potential location of the fault by at least: calculating a difference between a pre-fault power flow, existing prior to the detection of the fault, through the upstream measurement device, and a post-fault power flow, existing after the detection of the fault and isolation of the fault by a protection device, through the upstream measurement device; and generating a first set of one or more potentially blown downstream fuses by, for each of a plurality of downstream fuses that are on the downstream power distribution network, determining an expected power flow through the downstream fuse, determining whether or not the expected power flow matches the difference between the pre-fault power flow and the post-fault power flow, and when determining that the expected power flow matches the difference between the pre-fault power flow and the post-fault power flow, adding an identifier of the downstream fuse to the first set.

For each of the plurality of downstream fuses, determining whether or not the expected power flow matches the difference between the pre-fault power flow and the post-fault power flow may comprise: determining whether or not the

EP 4 687 248 A1

difference between the pre-fault power flow and the post-fault power flow is within a range of the expected power flow through the downstream fuse; when determining that the difference between the pre-fault power flow and the post-fault power flow is within the range of the expected power flow through the downstream fuse, determining that the expected power flow matches the difference between the pre-fault power flow and the post-fault power flow; and when determining that the difference between the pre-fault power flow and the post-fault power flow is not within the range of the expected power flow through the downstream fuse, determining that the expected power flow does not match the difference between the pre-fault power flow and the post-fault power flow.

For each of the plurality of downstream fuses, determining the expected power flow through the downstream fuse may comprise determining the expected power flow through the downstream fuse at a current time based on a power flow profile for the downstream fuse, wherein the power flow profile maps expected power flow for the downstream fuse over a time period. The method may further comprise using the at least one hardware processor to: periodically receive automated meter infrastructure (AMI) data from a plurality of automated meters on the downstream power distribution network; and generate the power flow profile for each of the plurality of downstream fuses based on the received AMI data. A plurality of power flow profiles may be generated for each of the plurality of downstream fuses based on the received AMI data, and the method may further comprise using the at least one hardware processor to, for each of the plurality of downstream fuses, select one of the plurality of power flow profiles, from which to determine the expected power flow through the downstream fuse, based on the current time. Generating the power flow profile for each of the plurality of downstream fuses may be further based on a network model of the downstream power distribution network.

Identifying the potential fault location may further comprise: determining a second set of one or more potentially blown downstream fuses based on one or more fault locations determined based on a peak fault current and a network model of the downstream power distribution network; and determining an overlapping set of one or more potentially blown downstream fuses by correlating the first set to the second set. The method may further comprise using the at least one hardware processor to, in response to the detection of the fault, determine a final blown downstream fuse from the overlapping set. Determining the final blown downstream fuse from the overlapping set may comprise determining one of the one or more potentially blown downstream fuses, in the overlapping set, that is associated with an outage report. The outage report may be received from a customer of the downstream power distribution network. The outage report may comprise a trouble call for the customer.

The method may further comprise using the at least one hardware processor to, in response to the detection of the fault, determine a final blown downstream fuse based on the first set. Determining the final blown downstream fuse based on the first set may comprise determining one of the one or more potentially blown downstream fuses, in the first set, that is associated with an outage report. The outage report may be received from a customer of the downstream power distribution network. The outage report may comprise a trouble call for the customer.

The upstream measurement device may comprise a recloser or circuit breaker relay. The upstream measurement device may comprise a line sensor. The at least one hardware processor may be comprised in an advanced distribution management system that manages the downstream power distribution network.

It should be understood that any of the features in the methods above may be implemented individually or with any subset of the other features in any combination. Thus, to the extent that the appended claims would suggest particular dependencies between features, disclosed embodiments are not limited to these particular dependencies. Rather, any of the features described herein may be combined with any other feature described herein, or implemented without any one or more other features described herein, in any combination of features whatsoever. In addition, any of the methods, described above and elsewhere herein, may be embodied, individually or in any combination, in executable software modules of a processor-based system, such as a server, and/or in executable instructions stored in a non-transitory computer-readable medium.

**BRIEF DESCRIPTION OF THE DRAWINGS**

The details of the present invention, both as to its structure and operation, may be gleaned in part by study of the accompanying drawings, in which like reference numerals refer to like parts, and in which:

FIG. 1 illustrates an example infrastructure, in which any of the processes described herein may be implemented, according to an embodiment;
FIG. 2 illustrates an example processing system, by which any of the processes described herein may be executed, according to an embodiment;
FIG. 3 illustrates an example data flow for determining fault location based on automated metering infrastructure (AMI) data, according to an embodiment;
FIG. 4 illustrates a power distribution network, according to an example;
FIG. 5 illustrates a process for determining fault location based on AMI data, according to an embodiment;
FIG. 6 illustrates an example power flow profile, according to an embodiment; and

FIGS. 7A and 7B illustrate example operations of a process for determining fault location based on AMI data, according to an embodiment.

**DETAILED DESCRIPTION**

In an embodiment, systems, methods, and non-transitory computer-readable media are disclosed for determining fault location based on automated metering infrastructure (AMI) data. After reading this description, it will become apparent to one skilled in the art how to implement the invention in various alternative embodiments and alternative applications. However, although various embodiments of the present invention will be described herein, it is understood that these embodiments are presented by way of example and illustration only, and not limitation. As such, this detailed description of various embodiments should not be construed to limit the scope or breadth of the present invention as set forth in the appended claims.

1. Infrastructure

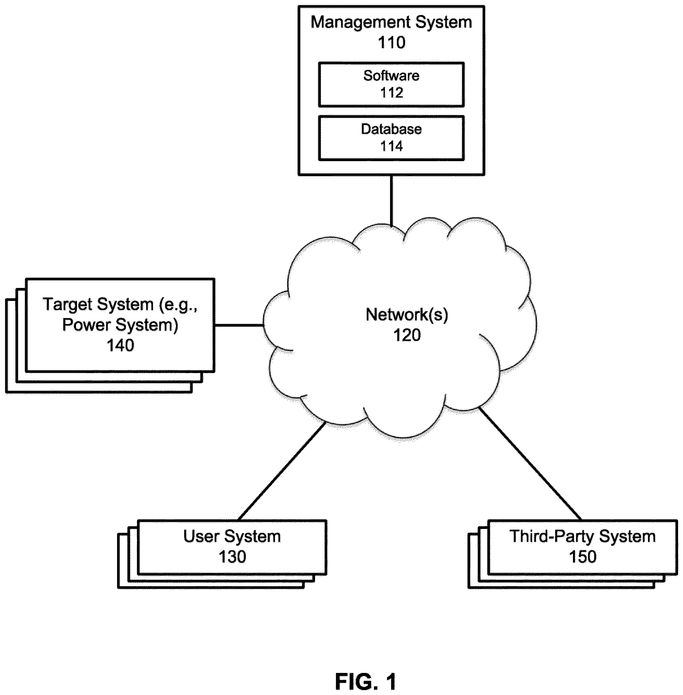

FIG. 1 illustrates an example infrastructure in which any of the disclosed processes may be implemented, according to an embodiment. The infrastructure may comprise a management system 110 (e.g., comprising one or more servers) that hosts and/or executes one or more of the various processes described herein, which may be implemented in software and/or hardware. Examples of management system 110 include, without limitation, a supervisory control and data acquisition (SCADA) system, a power management system (PMS), an energy management system (EMS), a distribution management system (DMS), an advanced distribution management system (ADMS), an asset management system (AMS), and the like. While it is generally contemplated that management system 110 would comprise or consist of an advanced distribution management system, this does not have to be the case. Management system 110 may comprise dedicated servers, or may instead be implemented in a computing cloud, in which the computational resources of one or more servers are dynamically and elastically allocated to multiple tenants based on demand. In either case, the servers may be collocated (e.g., in a single data center) and/or geographically distributed (e.g., across a plurality of data centers). Management system 110 may also comprise or be communicatively connected to software 112 and/or a database 114. In addition, management system 110 may be communicatively connected, via one or more networks 120, to one or more user systems 130, target systems 140, and/or third-party systems 150.

Network(s) 120 may comprise the Internet, and management system 110 may communicate with user system(s) 130, target system(s) 140, and/or third-party system(s) 150, through the Internet and/or other network using standard transmission protocols, such as HyperText Transfer Protocol (HTTP), HTTP Secure (HTTPS), File Transfer Protocol (FTP), FTP Secure (FTPS), Secure Shell FTP (SFTP), eXtensible Messaging and Presence Protocol (XMPP), Open Field Message Bus (OpenFMB), IEEE Smart Energy Profile Application Protocol (IEEE 2030.5), and the like, as well as proprietary protocols. While management system 110 is illustrated as being connected to various systems through a single set of network(s) 120, it should be understood that management system 110 may be connected to the various systems via different sets of one or more networks. For example, management system 110 may be connected to a subset of user systems 130, target systems 140, and/or third-party systems 150 via the Internet, but may be connected to one or more other user systems 130, target systems 140, and/or third-party systems 150 via an intranet. Furthermore, while only a few user systems 130, target systems 140, and third-party systems 150, one instance of software 112, and one database 114 are illustrated, it should be understood that the infrastructure may comprise any number of user systems 130, target systems 140, third-party systems 150, software instances 112, and databases 114.

User system(s) 130 may comprise any type or types of computing devices capable of wired and/or wireless communication, including without limitation, desktop computers, laptop computers, tablet computers, smart phones or other mobile phones, servers, game consoles, televisions, set-top boxes, electronic kiosks, point-of-sale terminals, embedded controllers, programmable logic controllers (PLCs), and/or the like. However, it is generally contemplated that user system(s) 130 would comprise personal computers, mobile devices, or workstations by which agents of an operator (e.g., utility) of a target system 140 (e.g., power network) can interact with management system 110. These interactions may comprise inputting data (e.g., parameters for configuring the processes described herein) and/or receiving data (e.g., the outputs of processes described herein) via a graphical user interface provided by management system 110 or a system between management system 110 and user system(s) 130. The graphical user interface may comprise screens (e.g., webpages) that include a combination of content and elements, such as text, images, videos, animations, references (e.g., hyperlinks), frames, inputs (e.g., textboxes, text areas, checkboxes, radio buttons, drop-down menus, buttons, forms, etc.), scripts (e.g., JavaScript), and the like, including elements comprising or derived from data stored in database 114.

Target system(s) 140 may comprise any type of system for which data are monitored, analyzed, and/or acted upon. However, in the context of specific, non-limiting examples that are provided throughout the present disclosure, it will be assumed that target system 140 comprises or consists of a power network, and particularly, a power distribution network. A power distribution network may comprise one or more, and generally a plurality of, power assets connected in a network. The power assets may comprise power resources, such as power generators, energy storage systems, electrical loads, and/or the like, as well as other types of power assets, such as transformers, inverters, branches or other lines, and/or any other electrical component supporting the power network. Power generators may comprise different types of power generators, such as thermal power plants (e.g., coal, natural gas, nuclear, geothermal, etc.), hydroelectric power plants, renewable resource power plants (e.g., solar, wind, geothermal, etc.), and/or the like. Electrical loads may comprise anything that consumes power, including, without limitation, electric vehicles, appliances, machines, commercial buildings, residential buildings, and/or the like.

Third-party system(s) 150 may comprise any type or types of computing devices capable of wired and/or wireless communication. However, it is generally contemplated that third-party system 150 would comprise one or more servers that supply extrinsic data to management system 100. The extrinsic data may represent historical, current, and/or forecasted values of one or more parameters, relevant to target system 140, such as weather parameters (e.g., temperature, humidity, wind speed, pressure, etc.), market parameters (e.g., energy prices), socio-political events (e.g., protests, law-enforcement warnings, etc.), and/or the like.

Management system 110 may execute software 112, comprising one or more software modules that implement one or more of the disclosed processes. In addition, management system 110 may comprise, be communicatively coupled with, or otherwise have access to database 114 that stores the data input into and/or output from one or more of the disclosed processes. Any suitable database may be utilized in database 114, including without limitation MySQL™, Oracle™, IBM™, Microsoft SQL™, Access™, PostgreSQL™, MongoDB™, and/or the like, and including cloud-based databases, proprietary databases, and unstructured databases.

2. Example Processing Device

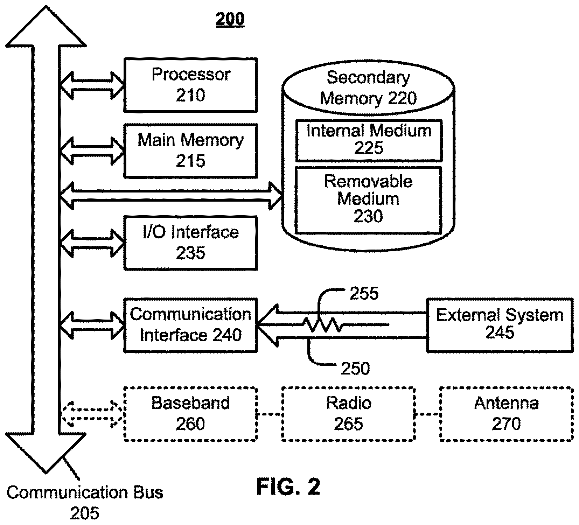

FIG. 2 illustrates an example processing system 200, by which any of the processes described herein may be executed, according to an embodiment. For example, system 200 may be used as or in conjunction with one or more of the functions, methods, or other processes (e.g., to store and/or execute software 112, store database 114, etc.) described herein, and may represent components of management system 110, user system(s) 130, target system(s) 140, third-party system(s) 150, and/or other processing devices described herein. System 200 can be a server, conventional personal computer, or any other processor-enabled device that is capable of wired or wireless data communication. Other computer systems and/or architectures may be also used, as will be clear to those skilled in the art.

System 200 preferably includes one or more processors 210. Processor(s) 210 may comprise a central processing unit (CPU). Additional processors may be provided, such as a graphics processing unit (GPU), an auxiliary processor to manage input/output, an auxiliary processor to perform floating-point mathematical operations, a special-purpose microprocessor having an architecture suitable for fast execution of signal-processing algorithms (e.g., digital-signal processor), a processor subordinate to the main processor (e.g., back-end processor), an additional microprocessor or controller for dual or multiple processor systems, and/or a coprocessor. Such auxiliary processors may be discrete processors or may be integrated with a main processor 210. Examples of processors 210 which may be used with system 200 include, without limitation, any of the processors (e.g., Pentium™, Core i7™, Xeon™, etc.) available from Intel Corporation of Santa Clara, California, any of the processors available from Advanced Micro Devices, Incorporated (AMD) of Santa Clara, California, any of the processors (e.g., A series, M series, etc.) available from Apple Inc. of Cupertino, any of the processors (e.g., Exynos™) available from Samsung Electronics Co., Ltd., of Seoul, South Korea, any of the processors available from NXP Semiconductors N.V. of Eindhoven, Netherlands, and/or the like.

Processor 210 may be connected to a communication bus 205. Communication bus 205 may include a data channel for facilitating information transfer between storage and other peripheral components of system 200. Furthermore, communication bus 205 may provide a set of signals used for communication with processor 210, including a data bus, address bus, and/or control bus (not shown). Communication bus 205 may comprise any standard or non-standard bus architecture such as, for example, bus architectures compliant with industry standard architecture (ISA), extended industry standard architecture (EISA), Micro Channel Architecture (MCA), peripheral component interconnect (PCI) local bus, standards promulgated by the Institute of Electrical and Electronics Engineers (IEEE), including IEEE 488 general-purpose interface bus (GPIB) or IEEE 696/S-100, and/or the like.

System 200 may comprise a main memory 215. Main memory 215 provides storage of instructions and data for programs executing on processor 210, such as one or more of the processes discussed herein (e.g., implemented in software 112). It should be understood that programs stored in the memory and executed by processor 210 may be written and/or compiled according to any suitable language, including without limitation C/C++, Java, JavaScript, Perl, Visual Basic, .NET, and the like. Main memory 215 is typically semiconductor-based memory such as dynamic random access memory (DRAM) and/or static random access memory (SRAM). Other semiconductor-based memory types include, for example, synchronous dynamic random access memory (SDRAM), Rambus dynamic random access memory (RDRAM), ferroelectric random access memory (FRAM), and the like, including read only memory (ROM).

System 200 may also comprise a secondary memory 220. Secondary memory 220 may optionally include an internal medium 225 and/or a removable medium 230. Internal medium 225 may comprise, for example, a hard disk drive (HDD), a solid state drive (SSD), and/or the like. Removable medium 230 may comprise, for example, a magnetic tape drive, a compact disc (CD) drive, a digital versatile disc (DVD) drive, a flash memory drive, and/or the like. Secondary memory 220 is a non-transitory computer-readable medium having computer-executable code (e.g., software 112) and/or other data stored thereon. The computer software or data stored on secondary memory 220 is read into main memory 215 for execution by processor 210.

System 200 may comprise an input/output (I/O) interface 235. I/O interface 235 provides an interface between one or more components of system 200 and one or more input and/or output devices. Example input devices include, without limitation, sensors, keyboards, touch screens or other touch-sensitive devices, cameras, biometric sensing devices, computer mice, trackballs, pen-based pointing devices, and/or the like. Examples of output devices include, without limitation, other processing devices, cathode ray tubes (CRTs), plasma displays, light-emitting diode (LED) displays, liquid crystal displays (LCDs), printers, vacuum fluorescent displays (VFDs), surface-conduction electron-emitter displays (SEDs), field emission displays (FEDs), and/or the like. In some cases, an input and output device may be combined, such as in the case of a touch-panel display (e.g., in a smartphone, tablet, or other mobile device).

System 200 may comprise a communication interface 240. Communication interface 240 allows software and other data to be transferred between system 200 and external devices, networks, or other external systems 245. For example, data, which may include computer software or executable code, may be transferred to system 200 from external system 245 (e.g., a network server, personal computer, or other device) and/or from system 200 to external system 245, via communication interface 240. Examples of communication interface 240 include a built-in network adapter, network interface card (NIC), Personal Computer Memory Card International Association (PCMCIA) network card, card bus network adapter, wireless network adapter, Universal Serial Bus (USB) network adapter, modem, a wireless data card, a communications port, an infrared interface, an IEEE 1394 fire-wire, and any other device capable of interfacing system 200 with a network (e.g., network(s) 120) or another computing device. Communication interface 240 preferably implements industry-promulgated protocol standards, such as Ethernet IEEE 802 standards, Fiber Channel, digital subscriber line (DSL), asynchronous digital subscriber line (ADSL), frame relay, asynchronous transfer mode (ATM), integrated services digital network (ISDN), personal communications services (PCS), transmission control protocol/Internet protocol (TCP/IP), serial line Internet protocol/point to point protocol (SLIP/PPP), and so on, but may also implement customized or non-standard interface protocols as well.

Data transferred via communication interface 240 are generally in the form of electrical communication signals 255. These signals 255 may be provided to communication interface 240 via a communication channel 250. In an embodiment, communication channel 250 may be a wired or wireless network (e.g., network(s) 120), or any variety of other communication links. Communication channel 250 carries signals 255 and can be implemented using a variety of wired or wireless communication means including wire or cable, fiber optics, conventional phone line, cellular phone link, wireless data communication link, radio frequency ("RF") link, or infrared link, just to name a few.

Computer programs (e.g., implemented in software 112), comprising computer-executable code or instructions, are stored in main memory 215 and/or secondary memory 220. Computer programs can also be received via communication interface 240 and stored in main memory 215 and/or secondary memory 220. The computer programs, when executed, may enable system 200 to perform one or more of the processes described elsewhere herein.

In this description, the term "computer-readable medium" is used to refer to any non-transitory computer-readable storage media used to provide computer-executable code and/or other data to or within system 200. Examples of such media include main memory 215, secondary memory 220 (including internal memory 225 and/or removable medium 230), and any peripheral device communicatively coupled with communication interface 240, such as external system 245. These non-transitory computer-readable media are means for providing executable code, programming instructions, software, and/or other data to processor(s) 210.

System 200 may also include optional wireless communication components that facilitate wireless communication over a voice network and/or a data network (e.g., in the case of user system 130 that is a smart phone or other mobile device, a sensor and/or actuator within target system 140, etc.). The wireless communication components comprise an antenna system 270, a radio system 265, and a baseband system 260. In system 200, radio frequency (RF) signals are transmitted and received over the air by antenna system 270 under the management of radio system 265.

In an embodiment, antenna system 270 may comprise one or more antennae and one or more multiplexors (not shown) that perform a switching function to provide antenna system 270 with transmit and receive signal paths. In the receive path, received RF signals can be coupled from a multiplexor to a low noise amplifier (not shown) that amplifies the received RF signal and sends the amplified signal to radio system 265.

In an alternative embodiment, radio system 265 may comprise one or more radios that are configured to communicate over various frequencies. In an embodiment, radio system 265 may combine a demodulator (not shown) and modulator (not shown) in one integrated circuit (IC). The demodulator and modulator can also be separate components. In the incoming path, the demodulator strips away the RF carrier signal leaving a baseband receive signal, which is sent from radio system 265 to baseband system 260.

Baseband system 260 is also communicatively coupled with processor(s) 210, which may have access to data storage areas, such as main memory 215 and/or secondary memory 220. Thus, data, including computer programs, can be received from baseband processor 260 and stored in main memory 210 or in secondary memory 220, or executed upon receipt. Such computer programs, when executed, may enable system 200 to perform one or more of the disclosed processes.

3. Example Data Flow for Target System Management

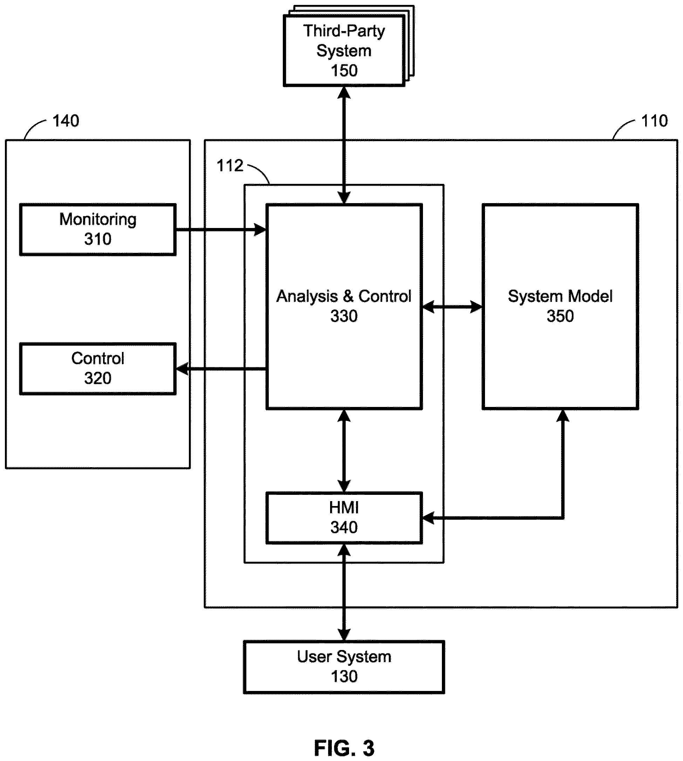

FIG. 3 illustrates an example data flow between a management system 110, a user system 130, a target system 140, and one or more third-party systems 150, according to an embodiment. It is generally contemplated that target system 140 will be a power network, and more particularly, a power distribution network. Target system 140 may comprise a monitoring module 310 and a control module 320. Software 112 of management system 110 may comprise an analysis and control module 330, and a human-to-machine interface (HMI) 340. Analysis and control module 330 may interact with or comprise a system model 350, which may be stored in database 114 of management system 110. It should be understood that communications between the various systems may be performed via network(s) 120. In addition, communications between a pair of modules may be performed via an application programming interface (API) provided by one of the modules or by other inter-process communication means.

Monitoring module 310 may monitor and collect data that are output by one or more sensors in target system 140 (e.g., sensors in the power network). Monitoring module 310 may also otherwise derive data from the collected data. Monitoring module 310 may transmit or "push" the collected and/or otherwise derived data as system telemetry to analysis and control module 330 (e.g., via an API of analysis and control module 330). Alternatively, analysis and control module 330 may retrieve or "pull" the system telemetry from monitoring module 310 (e.g., via an API of monitoring module 310). The system telemetry may include measurements at each of one or more nodes (e.g., buses) or other points within a power network of target system 140. The system telemetry may be communicated from monitoring module 310 to analysis and control module 330 in real time, as data are collected and/or otherwise derived, or periodically. As used herein, the term "real time" includes events that occur simultaneously, as well as events that are separated in time by ordinary delays resulting from latencies in processing, memory access, communications, and/or the like.

Analysis and control module 330 may receive the system telemetry from monitoring module 310, use the system telemetry, potentially in conjunction with system model 350, to perform analysis on target system 140 (e.g., fault location), and then potentially control target system 140 based on the analysis (e.g., to perform or facilitate fault isolation, service restoration, etc.). In particular, analysis and control module 330 may generate control signals that are transmitted to control module 320 of target system 140. For example, the control signals may be sent via an API of control module 320. The control signals may be communicated from analysis and control module 330 of management system 110 to control module 320 of target system 140 in real time, as the system telemetry is received and analyzed, periodically (e.g., in advance of a sliding time window), and/or in response to a user operation. Analysis and control module 330 may control target system 140 automatically (e.g., without any user intervention), semi-automatically (e.g., requiring user approval or confirmation), and/or in response to manual user inputs.

Each third-party system 150 may supply extrinsic data to analysis and control module 330. Third-party system 150 may transmit or push the extrinsic data to analysis and control module 330 (e.g., via an API of analysis and control module 330). Alternatively, analysis and control module 330 may retrieve or pull the extrinsic data from third-party system 150 (e.g., via an API of third-party system 150). The extrinsic data may include any data that are utilized by analysis and control module 330 and that are not available from an intrinsic source, such as monitoring module 310 or database 114. The extrinsic data may comprise or consist of data that are exogenous to target system 140. Of particular relevance to disclosed embodiments, these extrinsic data may comprise outage reports. An outage report may be a telephone call by or for a customer experiencing an outage, the submission of an outage indication via a website or mobile application on the customer's device, and/or the like.

Analysis and control module 330 may receive intrinsic data from monitoring module 310 and/or database 114 and/or receive extrinsic data from one or more third-party systems 150, analyze these data, and make decisions and/or perform operations on target system 140, based on this analysis. As an example, analysis and control module 330 may utilize the analysis to locate a fault in target system 140, determine a configuration of target system 140 (e.g., to isolate a fault, restore service after a fault, etc.), and/or the like. In the event that a configuration is determined, analysis and control module 330 may automatically (i.e., without any user involvement), semi-automatically (e.g., with user approval or confirmation via human-to-machine interface 340), or manually (e.g., in response to a manual user request) initiate a control operation, to change a real-time or scheduled operation of target system 140, based on the determined configuration. Initiation of the control operation may comprise transmitting control commands to control module 320 of target system 140, which may responsively control target system 140 according to the control commands.

Control module 320 of target system 140 receives the control signals from analysis and control module 330, and controls one or more components of target system 140 in accordance with the control signals. In the context of a power system, such as a power distribution network, examples of such control include, without limitation, setting a setpoint (e.g., active and/or reactive power for power generators, voltage, etc.), adjusting the power output of a power generator, adjusting the charging or discharging of an energy storage system, adjusting the power input to a load, activating or deactivating a load, closing or opening a switch (e.g., circuit breaker), and/or the like.

Human-to-machine interface 340 may generate a graphical user interface that is transmitted to user system 130 and receive inputs to the graphical user interface via user system 130. The graphical user interface may provide information regarding the location of a fault determined by analysis and control module 330, the current state of target system 140 determined from the system telemetry, a predicted state of target system 140 determined by analysis and control module 330, a configuration of target system 140 determined by analysis and control module 330, a control decision or recommendation for target system 140 determined by analysis and control module 330, and/or the like. In addition, the graphical user interface may provide inputs that enable a user of user system 130 to configure settings of analysis and control module 330, configure system model 350, accept or reject decisions, or recommendations, specify, approve, and/or reject controls to be transmitted to control module 320 of target system 140, analyze target system 140, and/or the like.

Management system 110 may provide an individual system model 350 for each target system 140 that is managed by management system 110. Each system model 350 may comprise a network model of target system 350, which represents the power network as, for example, a set of nodes, representing buses in the power network, and edges, representing electrical lines or other electrical connections between nodes in the power network. System model 350 may be stored as a data structure in database 114 and accessed by modules, such as analysis and control module 330, via any known means (e.g., via an API of database 114, a direct query of database 114, etc.).

4. Example Power System

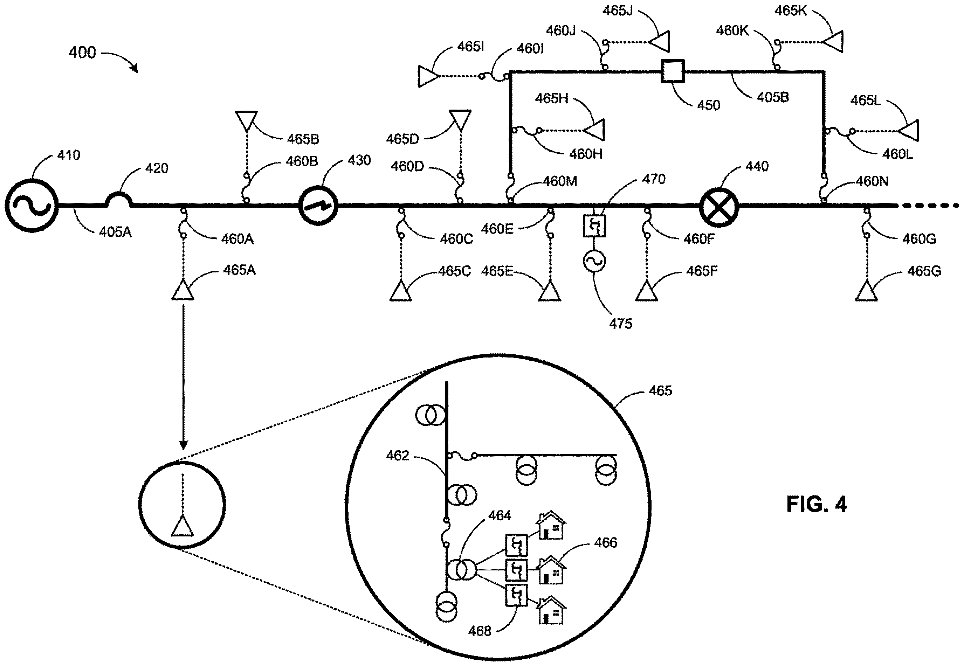

FIG. 4 illustrates a power distribution network 400, according to an example of target system 140. Power distribution network 400 comprises a radial distribution feeder 405 that originates from a distribution substation 410. Feeder 405 comprises a main feeder 405A and a lateral feeder 405B. As used herein, a reference numeral with an appended letter will be used to refer to a specific component, whereas the same reference numeral without any appended letter will be used to refer collectively to a plurality of the component or to refer to a generic or arbitrary instance of the component. Thus, for example, the term "feeders 405" refers collectively to main feeder 405A and lateral feeder 405B, and the term "feeder 405" may refer to any single one of main feeder 405A or lateral feeder 405B.

Feeder 405 may comprise a circuit breaker 420 that protects the entire feeder 405, one or more line sensors 430 (e.g., in a fault indicator, sectionalizer, digital fault recorder (DFR), protection relay, etc.), one or more reclosers 440, and/or one or more normally-open (NO) tie switches (SW) 450 that may be closed to form a loop. Feeder 405 may be electrically connected to one or more fuses 460, which each connects a fuse-protected lateral 465 to feeder 405, and/or one or more distributed energy resource 475 with a merchant power plant (MPP) meter 470 at a point of common coupling between each distributed energy resource 475 and feeder 405.

Each line sensor 430, which may form part of a fault indicator (e.g., for fault detection), sectionalizer (e.g., for fault isolation), digital fault recorder, or the like, is configured to detect power flow, which may also be referred to herein as "load," on an electrical line. Line sensor 430 may be used to detect the peak fault current on feeder 405. Each line sensor 430 may transmit observed fault currents, including the peak fault current, on the electrical line, to management system 110 (e.g., via monitoring module 310), at one or more time points. For example, a fault indicator may register the fault current on the electrical line whenever the fault indicator is triggered.

As is well known in the art, a recloser 440 is an automatic electric switch that trips (i.e., opens) when a fault is detected. However, unlike an ordinary circuit breaker, which remains open until being manually reset, a recloser 440 automatically tests the electrical line to determine whether or not the fault has been removed. If the fault was only temporary, recloser 440 will automatically reset itself and restore electric power. If the fault remains, recloser 440 will continue to periodically trip, according to a protection curve, until the fault is gone.

In the illustrated example, power distribution network 400 comprises fuses 460A, 460B, 460C, 460D, 460E, 460F, 460G, 460H, 4601, 460J, 460K, and 460L, which connect laterals 465A, 465B, 465C, 465D, 465E, 465F, 465G, 465H, 4651, 465J, 465K, and 465L, respectively, to feeder 405, as well as fuses 460M and 460N, which connect main feeder 405A to lateral feeder 405B. It should be understood that power distribution network 400 may comprise any number of fuses 460 and laterals 465 at any points along feeder 405, downstream from circuit breaker 420.

As used herein, the terms "upstream" and "downstream" are relative to a traversal of power distribution network 400 starting from distribution station 410 as the root and ending in laterals 465 as leaf nodes. This generally corresponds to the direction of power flow from distribution station 410 to laterals 465, assuming no loops and no return power flow. Thus, for example, each fuse 460 is upstream from its respective lateral 465, and each lateral 465 is downstream from its respective fuse 460.

As is well known in the art, a fuse 460 is an electrical safety device that provides overcurrent protection on the electrical line. In particular, when too much current flows through a fuse 460, a metal wire or strip, which provides electrical conductivity through the fuse 460, melts or "blows" to thereby stop or interrupt the current. It should be understood that, in a radial distribution feeder 405, a blown fuse 460 may result in an electrical outage on the respective lateral 465.

Each lateral 465 may comprise one or more electrical lines 462 and one or more service transformers 464 that supply electric power to one or more loads 466 (e.g., customers' residences, commercial buildings, etc.). The power flow to each load 466 may be measured by an automated meter reading (AMR) device 468 between service transformer 464 and load 466. It should be understood that power flow to a load 466 could be negative if the load 466 is connected to a behind-the-meter energy resource (e.g., photovoltaic solar panels on the roof of a building). Each AMR device 468 may communicate the measured power flow to management system 110 at a set sampling rate. In particular, the measured power flow may be transmitted to management system 110 (e.g., via monitoring module 310) at the expiration of each of a plurality of time intervals (e.g., every minute, every five minutes, every ten minutes, every fifteen minutes, etc.). In a preferred embodiment, the time interval is sufficiently short that the power flow can be assumed to be stable over the time interval.

## 5. Determination of Fault Location

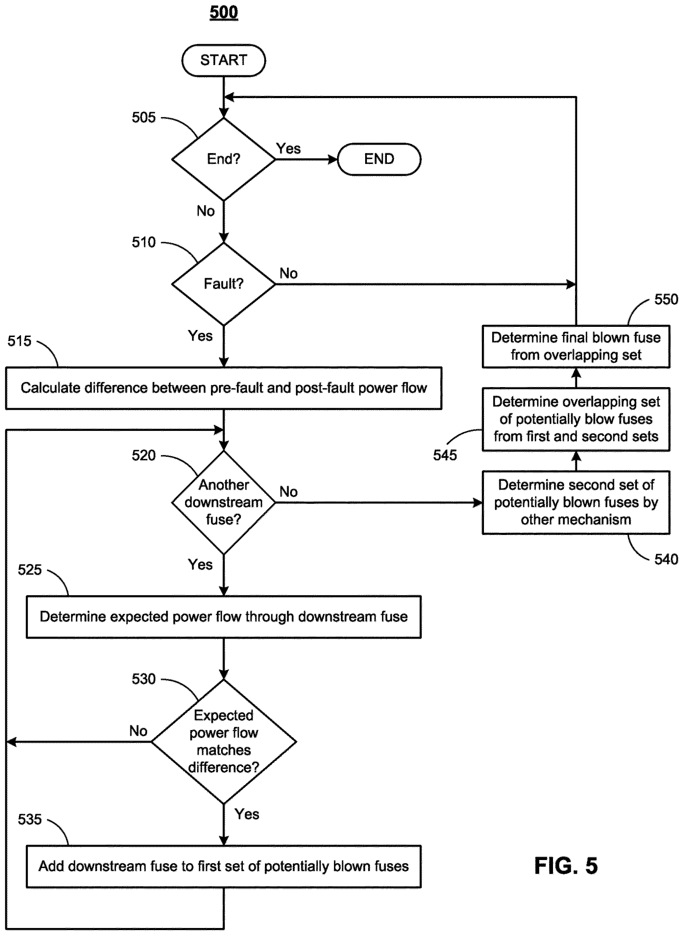

FIG. 5 illustrates a process 500 for determining fault location based on AMI data, according to an embodiment. Process 500 may be implemented in software 112, for example, within analysis and control module 330 of software 112, on management system 110, which may be an advanced distribution management system. A separate process 500 may be performed for each power distribution network 400 of each target system 140 that is managed by management system 110.

While process 500 is illustrated with a certain arrangement and ordering of subprocesses, process 500 may instead be implemented with fewer, more, or different subprocesses and a different arrangement and/or ordering of subprocesses. In addition, it should be understood that any subprocess, which does not depend on the completion of another subprocess, may be executed before, after, or in parallel with that other independent subprocess, even if the subprocesses are described or illustrated in a particular order.

Subprocess 505 may determine whether or not to end process 500. Process 500 may execute continuously or continually for as long as power distribution network 400 is operational. Alternatively or additionally, process 500 may be toggled on and off by an operator (e.g., utility) of power distribution network 400, via human-to-machine interface 340. When determining to end process 500 (i.e., "Yes" in subprocess 505), for example, because power distribution network 400 is no longer operational or the operator has turned off process 500, process 500 may end. Otherwise, when not determining to end process 500 (i.e., "No" in subprocess 505), process 500 may proceed to subprocess 510.

Subprocess 510 may determine whether or not a fault has been detected. In particular, a measurement device may detect a fault on at least a portion of power distribution network 400 that is downstream from the measurement device. Subprocess 510 may be executed periodically according to a fixed time interval (e.g., which may be a configurable parameter, determined by the data acquisition and computing resources of management system 110, in consideration of the operator's requirements), to determine whether or not any faults where detected in the most recent time interval, by analyzing data captured by line sensor 430, operation records of recloser 440, and/or the like, within the most recent time interval. Alternatively, subprocess 510 may be automatically triggered whenever a fault is detected.

The at least a portion of power distribution network 400 on which the fault is detected may be referred to herein as the "downstream power distribution network," and the measurement device that detects the fault may be referred to herein as an "upstream measurement device," since it is upstream from the downstream power distribution network. The upstream measurement device may be a fault indicator, sectionalizer, digital fault recorder, line sensor 430, recloser 440, circuit breaker relay, or the like. The upstream measurement device may be separate from, combined with, or comprised in a protection device that is configured to isolate the fault, once detected. Examples of a protection device include, without limitation, a sectionalizer, recloser 440, circuit breaker relay, and the like. When determining that a fault has been detected (i.e., "Yes" in subprocess 510), process 500 may proceed to subprocess 515. Otherwise, when not determining that a fault has been detected (i.e., "No" in subprocess 510), process 500 may return to subprocess 505 to await the detection of a fault.

In response to the detection of a fault on a downstream power distribution network by an upstream measurement device, at least subprocesses 515-550 are executed to identify a potential location of the fault. The upstream measurement device may be selected as the most downstream measurement device that detected a downstream fault. In other words, software 112 may cycle through data for all measurement devices on power distribution network 400 and select the most downstream measurement device that detected a fault. For example, if both line sensor 430 and recloser 440 detected a downstream fault, recloser 440 would be selected as the upstream measurement device, whereas, if only line sensor 430 detected a downstream fault, line sensor 430 would be selected as the upstream measurement device. In an embodiment, a measurement device that is on a loop (e.g., recloser 440, when tie switch 450 is closed) is ignored. In the case of a loop (e.g., when tie switch 450 is closed), the most downstream measurement device that is upstream from the loop (e.g., line sensor 430) may be selected as the upstream measurement device.

The downstream power distribution network consists of the portion of power distribution network 400 that is downstream from the selected upstream measurement device. For example, if line sensor 430 is selected as the upstream measurement device, the downstream power distribution network comprises fuses 460C-460L with respective laterals 465C-465L, whereas, if recloser 440 is selected as the upstream measurement device, the downstream power distribution network comprises fuses 460G, 460K, and 460L with respective laterals 465G, 465K, and 465L, assuming that tie switch 450 is open.

Subprocess 515 may calculate the difference between the pre-fault power flow and post-fault power flow through the selected upstream measurement device. It should be understood that the pre-fault power flow is the steady-state power flow, measured through the upstream measurement device, that existed prior to the detection of the fault. The post-fault power flow may be the steady-state power flow, measured through the upstream measurement device, that exists after the detection and isolation of the fault by a protection device. The upstream measurement device and the protection device may be the same device or different devices. An example of a device that comprises both the upstream measurement device and the protection device is recloser 440. In this case, subprocess 515 may be initiated after recloser 440 has completed the reclosing sequence, which ends in a closed state. In the case of a fault indicator (e.g., comprising line sensor 430), subprocess 515 may be initiated after the fault indicator has been triggered. It should be understood that, at this point, all that is known is that there is a blown fuse 460 on the downstream power distribution network. It is unknown which fuse 460 on the downstream power distribution network is blown, since fuses 460 do not generally have their own measurement devices. However, the sudden drop in power flow (i.e., from the pre-fault power flow to the post-fault power flow) provides information, which is used in the subsequent subprocesses to determine which fuse 460 has blown.

The difference between the pre-fault and post-fault power flows may be expressed as:

$$\Delta P = P_{pre} - P_{post}$$

wherein $\Delta P$ represents the difference, $P_{pre}$ represents the pre-fault power flow, and $P_{post}$ represents the post-fault power flow. In an embodiment, subsequent subprocesses are only triggered when:

$$\Delta P > \varepsilon$$

wherein $\varepsilon$ is a tolerance, representing normal variation in the power flow. The value of the tolerance $\varepsilon$ may be determined by heuristic rules, learned from artificial intelligence, and/or the like. In an embodiment, when $\Delta P \leq \varepsilon$, process 500 may return to subprocess 505 to await another detection of a fault. For simplicity, it is assumed that $\Delta P > \varepsilon$ when a fault is detected in subprocess 510.

Next, a first set of one or more potentially blown downstream fuses 460 is generated by iterating, as represented by subprocesses 520-535, through each fuse 460 on the downstream power distribution network. At a high level, one or more downstream fuses 460 are added to the first set based on the difference between the pre-fault and post-fault power flows, calculated in subprocess 515, and the expected power flow through each fuse 460 at the current time. In particular, each fuse 460, for which the expected power flow matches the difference between the pre-fault and post-fault power flow, is a candidate for the blown fuse 460. This is because the blowing of the fuse 460 would result in the loss of the expected power flow, which, if matching, would explain the difference in power flow, through the upstream measurement device, from the pre-fault value to the post-fault value. It should be understood that the difference between the pre-fault and post-fault power flows will be a decrease in power flow, since a portion of the power network is no longer drawing power, as a result of the blown fuse 460.

Subprocess 520 may determine whether or not another downstream fuse 460 remains to be considered. As mentioned above, subprocess 520 iterates through each fuse 460 on the downstream power distribution network, such that each and every downstream fuse 460 may be considered. When another downstream fuse 460 remains to be considered (i.e., "Yes" in subprocess 520), process 500 may proceed to subprocess 525. Otherwise, when no more downstream fuses 460 remain to be considered (i.e., "No" in subprocess 520), process 500 may proceed to subprocess 540.

Subprocess 525 may determine the expected power flow through the downstream fuse 460 currently being considered. It should be understood that the expected power flow is the power flow that is expected to be flowing through the downstream fuse 460 at the current time, based, for example, on historical power flow through that downstream fuse 460 during similar time periods. It should be understood that, as used herein, the term "current time" corresponds to the time at which or contemporaneously with the time at which post-fault power flow, used for the calculation in subprocess 515, is measured by the upstream measurement device. The expected power flow for the downstream fuse 460 at the current time may be determined based on a power flow profile for the downstream fuse 460.

Each power flow profile may map expected power flow for a fuse 460 over a time period. In particular, a power flow profile for a fuse 460 may define the expected power flow through the fuse 460 as a function of time. A single fuse 460 may be associated with one or a plurality of power flow profiles. In the case of a plurality of power flow profiles for a single fuse 460, each power flow profile may be associated with a different time period, such as a different day of the week, a different week of the month, a different month of the year, a different season of the year, a holiday, a weekday, a weekend, or the like. Subprocess 525 may select one of the plurality of power flow profiles, from which to determine the expected power flow through the fuse 460, based on the current time. In particular, subprocess 525 may select the power flow profile that corresponds to the time period encompassing the current time.

The power flow profile(s) associated with each fuse 460 may be generated by software 112 based on automated meter infrastructure (AMI) data, and maintained in database 114 for utilization in process 525. In particular, software 112 may periodically receive AMI data from a plurality of AMR devices 468 or other automated meters, on power distribution network 400, which includes the downstream power distribution network. The periodicity at which the AMI data are received may correspond to the sampling rate at which power flow is measured by AMR devices 468 (e.g., be equal to or some multiple of the sampling rate). Software 112 may generate the power flow profile for each of the plurality of fuses 460 on power distribution network 400 based on the received AMI data. For example, software 112 may generate a function that defines the power flow curve, as the power flow profile, takes a time as the input, and outputs the expected power flow for that time. As an alternative example, software 112 may generate a table, as the power flow profile, which lists the expected power flow for each of a plurality of time intervals. In any case, one or more power flow profiles are generated and maintained for each fuse 460 in power distribution network 400 based on the received AMI data.

In an embodiment, a power flow profile for a fuse 460 or other device on power distribution network 400 may also be generated based on a network model of power distribution network 400. The network model may be or be comprised in system model 350. In other words, the power flow profile may be based on both the AMI data and a network model of the power distribution network 400. As an example, the power flow profile of an upstream device (e.g., fuse 460) may be generated as an aggregate of the power flow profiles of all devices (e.g., fuses 460) that are determined to be downstream from that upstream device based on the network model. This may be useful when there is not AMI data for a particular device, but there are AMI data for devices that are downstream from that device.

Subprocess 530 may determine whether or not the expected power flow, determined in subprocess 525 for the current downstream fuse 460 being considered, matches the difference between the pre-fault power flow and the post-fault power flow, calculated in subprocess 515. In an embodiment, the expected power flow matches the difference between the pre-fault and post-fault power flows when the difference between the pre-fault and post-fault power flows is within a range of the expected power flow, or the expected power flow is within a range of the difference between the pre-fault and post-fault power flows. Thus, a match may be determined when the expected power flow is equal to or similar to the difference between the pre-fault and post-fault power flows. The range may be defined as a tolerance $\delta$ both above and below the value of the expected power flow (or above and below the difference between the pre-fault and post-fault power flows), such that the width of the range is $2\delta$. The value of $\delta$ may be a predefined tuning parameter that is determined by heuristic rules, learned from artificial intelligence, and/or the like. In an alternative embodiment, the range may not be centered on the expected power flow, but may be skewed to include a larger portion of the range above or below the value of the expected power flow (or above and below the difference between the pre-fault and post-fault power flows).

As an example, subprocess 530 may comprise determining whether or not the difference between the pre-fault power flow and the post-fault power flow is within the range of the expected power flow, determined in subprocess 525, through the downstream fuse 460 currently being considered. When determining that the difference between the pre-fault power flow and the post-fault power flow is within the range of the expected power flow through the downstream fuse 460, subprocess 530 may determine that the expected power flow matches the difference between the pre-fault power flow and the post-fault power flow. Conversely, when determining that the difference between the pre-fault power flow and the post-fault power flow is not within the range of the expected power flow through the downstream fuse 460, subprocess 530 may determine that the expected power flow does not match the difference between the pre-fault power flow and the post-fault power flow.

As an alternative example, subprocess 530 may comprise determining whether or not the expected power flow, determined in subprocess 525, through the downstream fuse 460 currently being considered, is within the range of the difference between the pre-fault power flow and the post-fault power flow. When determining that the expected power flow through the downstream fuse 460 is within the range of the difference between the pre-fault power flow and the post-fault power flow, subprocess 530 may determine that the expected power flow matches the difference between the pre-fault power flow and the post-fault power flow. Conversely, when determining that the expected power flow through the downstream fuse 460 is not within the range of the difference between the pre-fault power flow and the post-fault power flow, subprocess 530 may determine that the expected power flow does not match the difference between the pre-fault power flow and the post-fault power flow.

Regardless of the embodiment, when determining that the expected power flow matches the difference between the pre-fault power flow and the post-fault power flow (i.e., "Yes" in subprocess 530), process 500 may proceed to subprocess 535. Otherwise, when determining that the expected power flow does not match the difference between the pre-fault power flow and the post-fault power flow (i.e., "No" in subprocess 530), process 500 may return to subprocess 520 to determine whether or not another downstream fuse 460 remains to be considered.

Subprocess 535 may add the fuse 460 currently being considered to the first set of potentially blown downstream fuses 460. In particular, when subprocess 530 determines that the expected power flow for the fuse 460, currently being considered, matches the difference between the pre-fault and post-fault power flows, calculated in subprocess 515, subprocess 535 may add an identifier of the downstream fuse 460 to the first set of potentially blown downstream fuses 460. Essentially, any downstream fuse 460, for which the loss of expected power flow would account for the decrease in power flow through the upstream measurement device, is added to the first set.

Subprocess 540 may determine a second set of one or more potentially blown downstream fuses 460 using a second mechanism that is different from the first mechanism used to generate the first set in subprocesses 515-535. The second mechanism may comprise determining one or more fault locations based on peak fault current and the network model (e.g., system model 350) of the downstream power distribution network. In particular, these fault location(s) may be determined using the magnitude of peak fault current and peak time at each of one or more nodes in the downstream power distribution network to estimate the distance of the fault from the node. By determining the distance of the fault from one or a plurality of nodes, a location of the fault can be determined using the network model. Subprocess 540 may add an identifier of each downstream fuse 460 that corresponds to a potential location of the fault, as determined by this second mechanism, to the second set of potentially blown downstream fuses 460.

Subprocess 545 may determine an overlapping set of one or more potentially blown downstream fuses 460 by correlating the first set of potentially blown downstream fuse(s) 460 to the second set of potentially blown downstream fuse(s) 460. In particular, the identifier of each downstream fuse 460 that is in both the first set and the second set may be added to the overlapping set. In other words, the overlapping set may comprise or consist of every downstream fuse 460 that is in both the first set and the second set of potentially blown downstream fuses 460. Mathematically, the correlation in subprocess 545 may be expressed as:

$$\forall F1_i, i \in [1, N], \qquad if \ F1_i == F2_j, j \in [1, M],$$

*then add F*$1_i$ *to F0* wherein F1 is the first set, F2 is the second set, *N* is the number of potentially blown downstream fuses 460 in the first set, *M* is the number of potentially blown downstream fuses 460 in the second set, and F0 is the overlapping set.

Although not illustrated, in an alternative embodiment, a plurality of other mechanisms (e.g., third mechanism, fourth mechanism, etc.) may be used to determine potential fault locations in subprocess 540. In this case, each mechanism may produce a set of one or more potentially blown downstream fuses 460, representing each potential location of the fault that is determined by that mechanism. In such an embodiment, subprocess 545 may comprise determining an overlapping set of potentially blown fuses 460 by correlating all sets of potentially blown downstream fuses 460. In particular, the overlapping set may comprise or consist of every downstream fuse 460 that is in all or a threshold number of the sets of potentially blown downstream fuses 460 determined by the different mechanisms.

Subprocess 550 may determine the final blown downstream fuse 460 from the overlapping set of potentially blown downstream fuse(s) 460. When the overlapping set consists of only a single downstream fuse 460, subprocess 550 may determine the final blown downstream fuse 460 to be the single downstream fuse 460 in the overlapping set. On the other hand, when the overlapping set comprises two or more downstream fuses 460, subprocess 550 may select one of these downstream fuses 460 as the final blown downstream fuse 460, based on one or more criteria.

The one or more criteria may comprise the presence of an outage report for a downstream fuse 460 in the overlapping set. In other words, subprocess 550 may correlate the overlapping set of potentially blown downstream fuse(s) 460 to any received outage reports. Thus, subprocess 550 may determine one of the potentially blown downstream fuses 460, in the overlapping set, that is associated with an outage report, as the final blown downstream fuse 460. It should be understood that an outage represents a loss of electric power supply to a load 466.

The outage report may be received from a customer of the downstream power distribution network. It should be understood that a customer represents a load 466 on the downstream power distribution network. An outage report may be received via a telephone call (i.e., trouble call) by the customer or on behalf of the customer, the submission of an outage indication via a website or mobile application on the customer's device, or by any other means by which outages can be reported by a customer. Alternatively or additionally, the outage may be inferred from AMI data. For instance, the outage report may comprise a reading from a meter (e.g., an AMR device 468) that indicates zero power flow at the meter.

Additionally or alternatively, the one or more criteria may comprise the absence of an outage report, for a downstream fuse 460 in the overlapping set, within a predefined amount of time since the fault detection. For example, if no outage report is received for any load 466, downstream from a fuse 460 in the overlapping set, within a predefined amount of time since the fault detection, that fuse 460 may be filtered out of the overlapping set when determining the final blown downstream fuse in subprocess 550.

Additionally or alternatively, the one or more criteria may comprise the presence of a non-outage report for a downstream fuse 460 in the overlapping set. In other words, if it becomes known that there is power flowing through a fuse 460, that fuse 460 may be filtered out of the overlapping set when determining the final blown downstream fuse in subprocess 550. For example, if a subsequent reading from a meter (e.g., an AMR device 468), that is downstream from a fuse 460 in the overlapping set, indicates non-zero power flow to the load 466 behind the meter, that fuse 460 can be discarded as the potential fault location, such that it is filtered out of the overlapping set when determining the final blown downstream fuse in subprocess 550. In this case, the reading from the meter represents a non-outage report.

Outage and/or non-outage reports may be processed in real time and in parallel, after the fault detection in subprocess 510, and registered for utilization in the one or more criteria in subprocess 550. Subprocess 550 may wait for up to a predefined amount of time (e.g., after the fault detection in subprocess 510) before making a determination of the final blown downstream fuse 460. This provides time for outage and/or non-outage reports to be registered, so that a more informed and accurate decision may be made. In an embodiment in which subprocess 510 is executed periodically according to a fixed time interval, the predefined amount of time that subprocess 550 waits to make a determination may correspond to the fixed time interval (e.g., equal to the fixed time interval, a multiple of the fixed time interval, etc.).

It is generally contemplated that there will be a plurality of fuses 460 on the downstream power distribution network. In a scenario in which there is only a single fuse 460 on the downstream power distribution network (i.e., downstream from the upstream measurement device), that single fuse 460 must be the blown fuse 460. In this case, process 400 may proceed directly from subprocess 510 to subprocess 550, which then determines the single fuse 460 to be the final blown fuse 460.

In an alternative embodiment, no other mechanism may be used to determine a set of potentially blown fuses 460. In other words, in this alternative embodiment, only the first set of potentially blown downstream fuse(s) 460, generated by the first mechanism in subprocesses 515-535, is used to determine the final blown downstream fuse 460. In this case, subprocesses 540 and 545 may be omitted, and subprocess 550 may determine the final blown downstream fuse 460 based solely on the first set of potentially blown downstream fuse(s) 460, instead of an overlapping set of potentially blown downstream fuse(s) 460. In all other respects, in this alternative embodiment, subprocess 550 may determine the final blown downstream fuse 460 in the same manner as previously described (e.g., using one or more criteria, such as the presence of an outage report, absence of an outage report, presence of a non-outage report, etc.).

At a high level, when a fault is detected, process 500 matches the power drop through an upstream measurement device to the expected power flows through fuses 460, downstream from the upstream measurement device, based on power flow profiles for those fuses 460 (e.g., generated from historical AMI data and a network model), to produce a set of one or more downstream fuses 460 that represents potential fault location(s). This set may be correlated with at least one other mechanism for estimating fault locations, such as a mechanism that utilizes peak fault current and a network model, to produce an overlapping set of potentially blown downstream fuses 460. Then, a final blown downstream fuse 460, representing the most probable fault location, may be selected from this overlapping set based on one or more criteria.

It should be understood that, once a final blown downstream fuse 460 has been determined by subprocess 550, the identification of that fuse 460 may be used to trigger one or more remedial actions. An example of a remedial action is the dispatch of a crew to one or more locations at and/or downstream from the identified fuse 460, in order to diagnose the outage and restore service to the affected loads 466. Disclosed embodiments enable faster identification of the blown fuse 460, at lower computational complexity, which may reduce the amount of time and cost required to restore service.

It should be understood that there may be hundreds, thousands, tens of thousands, hundreds of thousands, millions, tens of millions or more of fuses 460 in power distribution network 400. In this case, an optimization method for locating faults becomes very complex and difficult to scale. Advantageously, process 500 is able to quickly identify a fault location without the computational complexity of an optimization method. In particular, all of the fuses 460, regardless of number or scale, may be quickly processed by subprocesses 515-535 to limit the search space for the final fault location determination in subprocess 550. Subprocesses 540 and 545 may be added to further limit the search space for subprocess 550. In an alternative embodiment of subprocess 550, the first set of potentially blown downstream fuses 460 may be used as an input to a more complex mechanism (e.g., optimization method) for identifying the final blown downstream fuse 460 in the limited search space of the first set.

6. Example Power Flow Profile

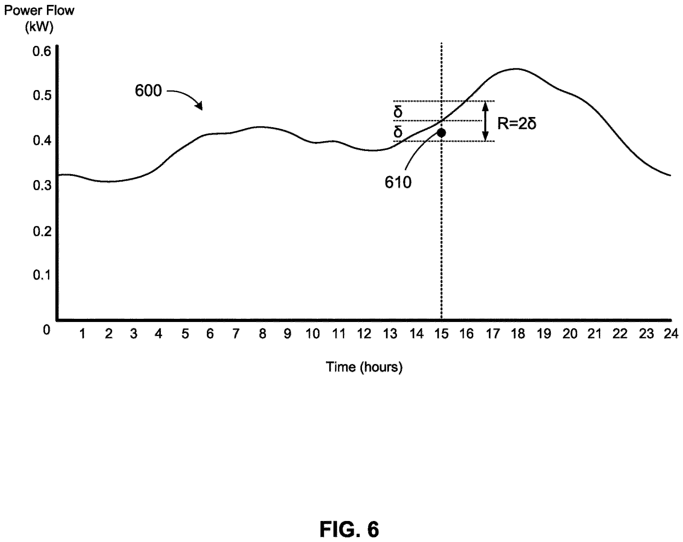

FIG. 6 illustrates an example power flow profile 600, according to an embodiment. In this example, power flow profile 600 represents a twenty-four hour period (e.g., from 12:00am to 11:59pm). As illustrated, power flow profile 600 defines power flow (e.g., in kilowatts) as a function of time (e.g., in hours).

Typically, a utility's meter data management system (MDMS) collects AMI data (e.g., from AMR devices 468) at fixed time intervals (e.g., every fifteen minutes). Power flow profile 600 may be calculated based on the energy consumption (e.g., in kilowatt hours) in the AMI data. It should be understood that the shorter the time interval for the AMI data (i.e., the greater the sampling rate), the greater the resolution of power flow profile 600. The AMI data, and resulting power flow profiles 600, may be aggregated for loads 466 to the level of service transformers 464 and then to the level of fuses 460 and other upstream devices, such as circuit breaker 420, line sensor 430, recloser 440, and the like, using the network model (e.g., system model 350). The result of this aggregation process may be at least one power flow profile 600 associated with each fuse 460 and/or other device in power distribution network 400.

Notably, conventional advanced distribution management systems only collect the load profile for service transformers 464. Advantageously, the aggregation process of disclosed embodiments enables power flow profiles 600 to be generated for devices upstream from service transformers 464. This enables management system 110 to determine how much power is flowing through each device in power distribution network 400, as a function of time, regardless of whether or not the AMI data comprise load information for that particular device. In other words, when actual load information is not available for a given device (e.g., fuse 460), the power flow profile 600 for that device may be determined by aggregating the load information for all devices that are downstream from that device. It should be understood that the downstream devices may be identified from the network model.

During the aggregation process, the losses of current-carrying components in power distribution network 400 may be estimated based on the network model (e.g., system model 350). Notably, any behind-the-meter distributed energy resources are automatically considered in the aggregation process. Generation by distributed energy resources 475 on main feeder 405A, which may be affected by weather and including possible curtailment directed by the utility based on operational conditions, will impact the power flow profile of upstream devices. For these distributed energy resources 475, the corresponding MPP meter 470 may provide the offset (e.g., in the AMI data) to be applied, in real time, to the power flow profile 600 generated for any upstream devices by the aggregation process. In other words, the offset for distributed energy resources 475 may be collected in real time and used to adjust the previously generated power flow profile 600, in subprocess 525, to produce an expected power flow that reflects network reality (e.g., weather, curtailment, etc.). In general, distributed energy resources 475 typically have fault-current-limiting capabilities, such that their contribution to process 500 is insignificant.

For purposes of illustration, it is assumed that a fault is detected at the fifteenth hour (e.g., 3:00pm). The difference 610, between the pre-fault and post-fault power flow, calculated in subprocess 515, is plotted relative to power flow profile 600 for a fuse 460 (e.g., being considered in subprocess 530). As illustrated, difference 610 is within a range $R = 2\delta$ that is centered at the expected power flow for fuse 460 at the fifteenth hour. Accordingly, in this example, the expected power flow for fuse 460 matches difference 610, between the pre-fault and post-fault power flows, in subprocess 530.

In an alternative embodiment, range $R$ could be defined relative to difference 610, instead of the expected power flow for fuse 460. In this case, the range $R = 2\delta$ would be centered on difference 610, between the pre-fault and post-fault power flows, and subprocess 530 would determine whether or not the expected power flow is within range $R$.

7. Example Operations

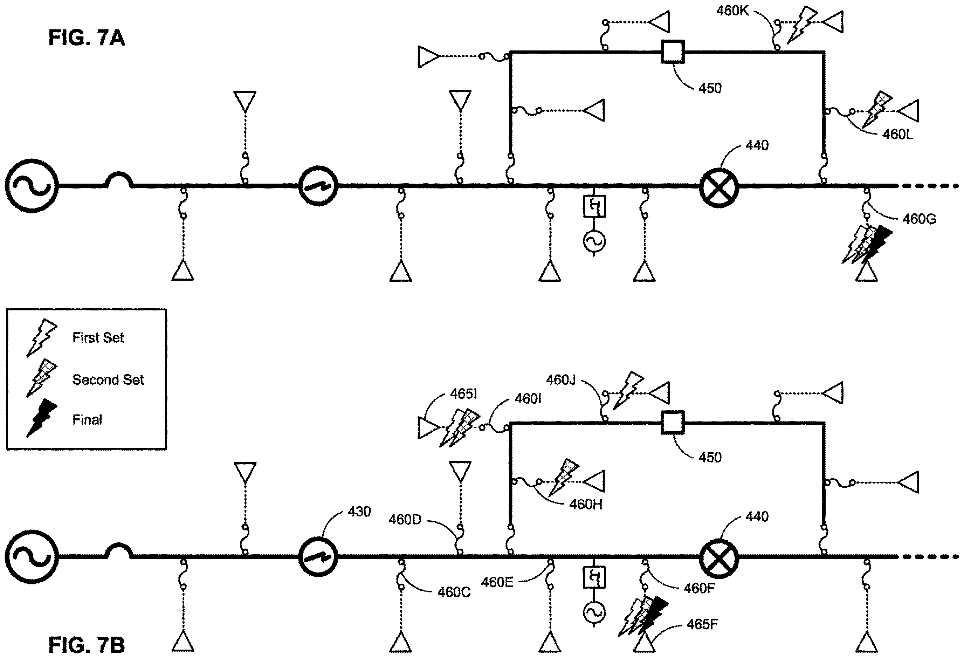

FIG. 7A illustrates a first example operation of process 500 for determining fault location based on AMI data, according to an embodiment. In this first example, recloser 440 detects a fault. It is assumed that tie switch 450 is open, such that the group of possibly blown downstream fuses 460 consists of fuses 460G, 460K, and 460L. The first set of potentially blown downstream fuses 460, generated by the first mechanism in subprocesses 515-535, consists of fuses 460K and 460G. The second set of potentially blown downstream fuses 460, generated by a second mechanism (e.g., peak fault current) in subprocess 540, consists of fuses 460L and 460G. Since fuse 460G is the only fuse 460 that is in both the first set and the second set, the overlapping set of potentially blown downstream fuses 460, generated by subprocess 545, consists of only fuse 460G. Because there is only fuse 460G in the overlapping set, subprocess 550 may determine fuse 460G as the final blown fuse 460, without having to resort to any criteria.

FIG. 7B illustrates a second example operation of process 500 for determining fault location based on AMI data, according to an embodiment. In this second example, line sensor 430 (e.g., in a fault indicator, sectionalizer, digital fault recorder, etc.) detects a fault, whereas recloser 440 does not detect a fault. Again, it is assumed that tie switch 450 is open, such that the group of possibly blown downstream fuses 460 consists of fuses 460C, 460D, 460E, 460F, 460H, 460I, and 460J. The first set of potentially blown downstream fuses 460, generated by the first mechanism in subprocesses 515-535, consists of fuses 460F, 460I, and 460J. The second set of potentially blown downstream fuses 460, generated by the second mechanism in subprocess 540, consists of fuses 460F, 460H, and 460I. Therefore, the overlapping set of potentially blown downstream fuses 460, generated by subprocess 545, consists of fuses 460F and 460I, since both of these fuses 460F and 460I are in both the first set and the second set. Because there are multiple fuses 460F and 460I in the overlapping set, subprocess 550 selects one of fuses 460F and 460I as the final blown downstream fuse 460, according to one or more criteria. In this second example, subprocess 550 selects fuse 460F as the final blown downstream fuse 460, based, for example, on the presence of an outage report associated with fuse 460F, the absence of an outage report associated with fuse 460I, the presence of a non-outage report associated with fuse 460I, and/or the like, within a predefined time period (e.g., from the time at which the fault was detected in subprocess 510).

Notably, in these example operations, the faults may occur within a portion of lateral 465. However, in an embodiment, the location of the fault is assigned to the nearest upstream fuse 460. Thus, for example, a fault occurring in an electrical line 462 of lateral 465F would be assigned to fuse 460F for the purposes of fault location according to the first mechanism.

The above description of the disclosed embodiments is provided to enable any person skilled in the art to make or use the invention. Various modifications to these embodiments will be readily apparent to those skilled in the art, and the general principles described herein can be applied to other embodiments without departing from the spirit or scope of the invention. Thus, it is to be understood that the description and drawings presented herein represent a presently preferred embodiment of the invention and are therefore representative of the subject matter which is broadly contemplated by the present invention. It is further understood that the scope of the present invention fully encompasses other embodiments that may become obvious to those skilled in the art and that the scope of the present invention is accordingly not limited.

As used herein, the terms "comprising," "comprise," and "comprises" are openended. For instance, "A comprises B" means that A may include either: (i) only B; or (ii) B in combination with one or a plurality, and potentially any number, of other components. In contrast, the terms "consisting of," "consist of," and "consists of" are closed-ended. For instance, "A consists of B" means that A only includes B with no other component in the same context.

Combinations, described herein, such as "at least one of A, B, or C," "one or more of A, B, or C," "at least one of A, B, and C," "one or more of A, B, and C," and "A, B, C, or any combination thereof' include any combination of A, B, and/or C, and may include multiples of A, multiples of B, or multiples of C. Specifically, combinations such as "at least one of A, B, or C," "one or more of A, B, or C," "at least one of A, B, and C," "one or more of A, B, and C," and "A, B, C, or any combination thereof' may be A only, B only, C only, A and B, A and C, B and C, or A and B and C, and any such combination may contain one or more members of its constituents A, B, and/or C. For example, a combination of A and B may comprise one A and multiple B's, multiple A's and one B, or multiple A's and multiple B's.

**Claims**

1. A method comprising using at least one hardware processor to, in response to a detection of a fault on a downstream power distribution network by an upstream measurement device that is upstream from the downstream power distribution network, identify a potential location of the fault by at least:

   calculating a difference between a pre-fault power flow, existing prior to the detection of the fault, through the upstream measurement device, and a post-fault power flow, existing after the detection of the fault and isolation of the fault by a protection device, through the upstream measurement device; and
   generating a first set of one or more potentially blown downstream fuses by, for each of a plurality of downstream fuses that are on the downstream power distribution network,

      determining an expected power flow through the downstream fuse,
      determining whether or not the expected power flow matches the difference between the pre-fault power flow and the post-fault power flow, and
      when determining that the expected power flow matches the difference between the pre-fault power flow and the post-fault power flow, adding an identifier of the downstream fuse to the first set.

2. The method of Claim 1, wherein, for each of the plurality of downstream fuses, determining whether or not the expected power flow matches the difference between the pre-fault power flow and the post-fault power flow comprises:

   determining whether or not the difference between the pre-fault power flow and the post-fault power flow is within a range of the expected power flow through the downstream fuse;
   when determining that the difference between the pre-fault power flow and the post-fault power flow is within the range of the expected power flow through the downstream fuse, determining that the expected power flow matches the difference between the pre-fault power flow and the post-fault power flow; and
   when determining that the difference between the pre-fault power flow and the post-fault power flow is not within the range of the expected power flow through the downstream fuse, determining that the expected power flow does not match the difference between the pre-fault power flow and the post-fault power flow.

3. The method of any one of the preceding claims, wherein, for each of the plurality of downstream fuses, determining the expected power flow through the downstream fuse comprises determining the expected power flow through the downstream fuse at a current time based on a power flow profile for the downstream fuse, wherein the power flow profile maps expected power flow for the downstream fuse over a time period.

4. The method of Claim 3, further comprising using the at least one hardware processor to:

periodically receive automated meter infrastructure (AMI) data from a plurality of automated meters on the downstream power distribution network; and
generate the power flow profile for each of the plurality of downstream fuses based on the received AMI data.

5. The method of Claim 4, wherein a plurality of power flow profiles are generated for each of the plurality of downstream fuses based on the received AMI data, and wherein the method further comprises using the at least one hardware processor to, for each of the plurality of downstream fuses, select one of the plurality of power flow profiles, from which to determine the expected power flow through the downstream fuse, based on the current time, and/or wherein generating the power flow profile for each of the plurality of downstream fuses is further based on a network model of the downstream power distribution network.

6. The method of any one of the preceding claims, wherein identifying the potential fault location further comprises:

determining a second set of one or more potentially blown downstream fuses based on one or more fault locations determined based on a peak fault current and a network model of the downstream power distribution network; and
determining an overlapping set of one or more potentially blown downstream fuses by correlating the first set to the second set.

7. The method of Claim 6, further comprising using the at least one hardware processor to, in response to the detection of the fault, determine a final blown downstream fuse from the overlapping set, and preferably wherein determining the final blown downstream fuse from the overlapping set comprises determining one of the one or more potentially blown downstream fuses, in the overlapping set, that is associated with an outage report.

8. The method of Claim 7, wherein the outage report is received from a customer of the downstream power distribution network, and preferably wherein the outage report comprises a trouble call for the customer.

9. The method of any one of the preceding claims, further comprising using the at least one hardware processor to, in response to the detection of the fault, determine a final blown downstream fuse based on the first set.

10. The method of Claim 9, wherein determining the final blown downstream fuse based on the first set comprises determining one of the one or more potentially blown downstream fuses, in the first set, that is associated with an outage report, and preferably

wherein the outage report is received from a customer of the downstream power distribution network, and further preferably wherein the outage report comprises a trouble call for the customer.

11. The method of any one of the preceding claims, wherein the upstream measurement device comprises a recloser or circuit breaker relay.

12. The method of any one of the preceding claims, wherein the upstream measurement device comprises a line sensor.

13. The method of any one of the preceding claims, wherein the at least one hardware processor is comprised in an advanced distribution management system that manages the downstream power distribution network.

14. A system comprising:

at least one hardware processor; and
software that is configured to, when executed by the at least one hardware processor, perform the method of any one of the preceding claims.

15. A non-transitory computer-readable medium having instructions stored therein, wherein the instructions, when executed by a processor, cause the processor to perform the method of any one of Claims 1 through 13.

Management System
110

Software
112

Database
114

Target System (e.g.,
Power System)
140

Network(s)
120

User System
130

Third-Party System
150

FIG. 1

**200**

FIG. 2

Third-Party
System
150

140

110

112

Monitoring
310

Analysis & Control
330

System Model
350

Control
320

HMI
340

User System
130

FIG. 3

FIG. 4

<u>500</u>

FIG. 5

21

**FIG. 6**

FIG. 7A

FIG. 7B

| | | |
|---|---|---|
| ⚡ | First Set | |
| ⚡ | Second Set | |
| ⚡ | Final | |

460K
460L
450
440
460G

4651
460I
460J
450
460H
430
460D
440
460C
460E
460F
465F

EP 4 687 248 A1

## EUROPEAN SEARCH REPORT

**Application Number**

EP 24 19 2171

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2007/055889 A1 (HENNEBERRY SCOTT M [US] ET AL) 8 March 2007 (2007-03-08) * paragraphs [0064] - [0067]; figure 1 * ----- | 1-15 | INV. H02J3/00 G01R31/08 H02H7/26 H02J13/00 |
| A | CN 105 425 107 A (ELECTRIC POWER RES INST OF STATE GRID SHANDONG ELECTRIC POWER CO ET AL) 23 March 2016 (2016-03-23) * paragraph [0059] * ----- | 1-15 | |
| A | CN 102 707 194 A (CHINA ELECTRIC POWER RES INST) 3 October 2012 (2012-10-03) * paragraphs [0072], [0073] * ----- | 1-15 | |
| A | US 2021/249853 A1 (MANDITEREZA PATRICK TENDAYI [ZA] ET AL) 12 August 2021 (2021-08-12) * paragraphs [0079], [0080] * ----- | 1-15 | |

**TECHNICAL FIELDS SEARCHED (IPC)**

H02J
G01R
H02H

The present search report has been drawn up for all claims

| Place of search | Date of completion of the search | Examiner |
|---|---|---|
| Munich | 18 December 2024 | Ramcke, Ties |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 2171

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2024

| Patent document cited in search report | Publication date | Patent family member(s) | Publication date |
|---|---|---|---|
| US 2007055889 A1 | 08-03-2007 | NONE | |
| CN 105425107 A | 23-03-2016 | NONE | |
| CN 102707194 A | 03-10-2012 | NONE | |
| US 2021249853 A1 | 12-08-2021 | GB 2592147 A | 18-08-2021 |
| | | KR 20210091141 A | 21-07-2021 |
| | | US 2021249853 A1 | 12-08-2021 |
| | | WO 2020107041 A1 | 28-05-2020 |
| | | ZA 202102427 B | 29-11-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Y. JIANG et al.** Outage Management of Distribution Systems Incorporating Information From Smart Meters. *IEEE Transactions on Power Systems*, September 2016, vol. 31 (5), 4144-4154
- **D. HAI et al.** Fault Location System for Distribution Network Based on Incomplete Information from Multiple Sources. *2021 6th International Conference on Smart Grid and Electrical Automation (ICSGEA), Kunming, China*, 2021, 378-382
- **D. S. PEREIRA et al.** An Experience of Locating High-impedance Faults through Smart Meters' Alarms in Power Distribution Networks. *CIRED 2021 - The 26th International Conference and Exhibition on Electricity Distribution, Online Conference*, 2021, 1727-1731